# EUROPÄISCHE PATENTSCHRIFT

(11) **EP 1 833 688 B1**
(45) Veröffentlichungstag und Bekanntmachung des Hinweises auf die Patenterteilung: **01.08.2012**
(21) Anmeldenummer: 05826416.9
(22) Anmeldetag: 13.12.2005
(51) Int. Cl.: B60C 23/04

(54) **REIFENMODUL SOWIE LUFTREIFEN MIT REIFENMODUL**
TYRE MODULE AND TYRE COMPRISING A MODULE OF THIS TYPE
MODULE DE PNEU ET PNEU EQUIPE D'UN TEL MODULE

(30) Priorität: 07.01.2005 DE 102005000996
(43) Veröffentlichungstag der Anmeldung: 19.09.2007
(73) Patentinhaber: Continental Teves AG & Co. oHG, 60488 Frankfurt am Main (DE)
(72) Erfinder: BEHRENDS, Holger, 30179 Hannover (DE); REIMANN, Carsten, 85080 Geimersheim (DE); KOSCHNITZKI, Thomas, 30167 Hannover (DE)
(86) Internationale Anmeldenummer: PCT/EP2005/056756
(87) Internationale Veröffentlichungsnummer: WO 2006/072539

(56) Entgegenhaltungen:
- EP-A1- 0 641 679
- DE-A1- 4 402 136
- US-A- 4 237 728
- US-A- 4 384 482
- US-A- 4 510 484
- US-A1- 2003 062 994
- US-B1- 6 252 336

## Beschreibung

Die Erfindung betrifft ein Reifenmodul zur Erfassung von Reifenzustandsgrößen mit einem einseitig eingespannten Federelement und einer Umwandlungseinheit, in der Bewegungsenergie in elektrische Energie umgewandelt wird, sowie einen Luftreifen mit einem solchen Reifenmodul.

Die Erfindung ist insbesondere dazu geeignet, Reifenzustandsgrößen und Fahrbahnbelagseigenschaften mit einem energieautarken System zu ermitteln.

Aus der DE 44 02 136 A1 ist ein System zur Bestimmung der Betriebsparameter von Fahrzeugreifen bekannt, bei dem auf einem Trägerkörper eine Sensoreinheit, eine Auswerteelektronik und ein piezoelektrisches Element angeordnet ist, das die übrige Systemkomponenten mit Energie versorgt. Das piezoelektrische Element weist einen mehrschichtigen Aufbau auf.

Weiterhin ist aus der DE 101 03 952 A1 eine Vorrichtung zur Energieversorgung eines Sensors bekannt, das einen passiven, piezoelektrischen Wandler aufweist, der durch einen mechanischen Energiespeicher deformierbar ist und eine entsprechende Spannung zum Betrieb des Sensors liefert. Der piezoelektrische Wandler ist durch die vom Energiespeicher abgegebene Verformungsarbeit biegbar. Der Aufbau mit einer Stabfeder und einer an dem freien Ende der Stabfeder angeordneten Druckfeder ist aufwendig.

Die US 4384482 und die US 4510484 offenbaren jeweils ein Reifenüberwachungssystem mit einem piezoelektrischen Element zur Energieversorgung.

Die US 20030062994 beschreibt ein Reifenüberwachungssystem mit einer drucksensitiven Einrichtung, die ein piezoelektrisches Element umfasst.

Aus der EP0641679 ist eine Vorrichtung zur Überwachung des Luftdrucks eines Reifens vorbekannt, die einen Sensor aufweist, der einen dem Ausmaß der Verformung des Reifens bei einem Latschdurchlauf entsprechenden elektrischen Impuls abgibt.

Ausgehend von diesem Stand der Technik liegt der Erfindung die Aufgabe zugrunde, ein verbessertes Reifenmodul bereitzustellen, mit dem einfach und zuverlässig eine Energieversorgung auch bei geringen Umdrehungszahlen des Reifens möglich ist.

Diese Aufgabe wird erfindungsgemäß durch ein Reifenmodul nach Anspruch 1 gelöst.

Es wird ein Reifenmodul bereitgestellt, bei dem das Federelement als Stab-, Torsions- oder Blattfeder ausgebildet ist, wobei an dem nicht eingespannten Ende des Federelementes eine seismische Masse angeordnet ist, die durch das Abrollen des Reifens mit einem Impuls beaufschlagt wird. Durch die Lagerung der seismischen Masse an dem Federelement entsteht ein Feder-Masseschwinger, der im Gegensatz zu herkömmlichen piezoelektrischen Energiewandlern einen erhöhten Wirkungsgrad hat. Die Schwingung wird dadurch erzeugt, dass das Reifenmodul sich während des Abrollens bei jedem Latschdurchtritt auf einer geraden Bahn bewegt, während es sich nach dem Latschaustritt auf einer Kreisbahn bewegt. Während der Kreisbahn wirkt die Zentrifugalkraft auf die seismische Masse, im Latsch ist sie idealerweise kraftfrei. Durch die Zentrifugalkraft wird der Feder-Masse-Schwinger ausgelenkt und strebt im Latsch die Rückkehr in seine Ruhelage an. Es kommt zum Über- und Nachschwingungen, wodurch die seismische Masse auch während der Phasen konstanter Kraft, also zwischen den Übergängen, in Bewegung ist. Dies ist für die elektrische Energiewandlung besonders günstig.

Eine Weiterbildung der Erfindung sieht vor, dass das Federelement in einem Gehäuse eingespannt ist und in Bewegungsrichtung zumindest ein piezoelektrisches Element mit dem Federelement gekoppelt ist. Das piezoelektrische Element wandelt die Bewegungsenergie des Feder-Masseschwingers in elektrische Energie um, die ihrerseits an Verbraucher weitergeleitet werden kann. Vorteilhafterweise sind piezoelektrische Elemente in jeder Bewegungsrichtung des Federelementes mit diesem gekoppelt, so dass bei einer Schwingung in den jeweiligen Ebenen in beiden Auslenkrichtungen von beiden piezoelektrischen Elementen elektrische Energie erhalten werden kann.

Zur Erzielung einer kompakten Bauweise ist das piezoelektrische Element bzw. sind die piezoelektrischen Elemente unmittelbar auf dem Federelement befestigt, so dass eine Auslenkung des Federelementes zu einer Dehnung oder Stauchung der piezoelektrischen Schicht führt, so dass an den entsprechenden Kontaktflächen eine elektrische Spannung abgegriffen werden kann.

Alternativ dazu ist es vorgesehen, dass die Umwandlungseinheit induktiv arbeitet. Dabei wird der Fluss eines magnetischen Kreises durch die Bewegung des Federelementes bzw. der seismischen Masse moduliert. Eine Ausgestaltung der induktiven Umwandlungseinheit sieht vor, dass das Federelement blattartig, vorzugsweise konzentrisch oder kreisförmig ausgebildet ist. Die seismische Masse ist dabei in der Mitte des blattartigen Federelementes, vorzugsweise im Schwerpunkt, angeordnet, wobei zur Schwingfähigkeit der blattartigen Feder Sicken, vorzugsweise konzentrische Sicken ausgebildet sind. Beim Durchlaufen der Reifenaufstandsfläche wird der Luftspalt zwischen Magnet und seismischer Masse verändert, wodurch sich der magnetische Fluss im Eisenkreis ändert. Die Flussänderung kann mit einer geeignet angeordneten Spule in eine elektrische Spannung umgesetzt werden.

Um den für einen Betrieb von elektrischen und elektronischen Elementen benötigten Gleichstrom zu erhalten, ist in einer Weiterbildung der Erfindung vorgesehen, dass das Reifemodul mit einem Gleichrichter versehen ist, der an der Umwandlungseinheit angeschlossen ist. Der Gleichrichter ist vorzugsweise als ein Brückengleichrichter ausgebildet.

Damit eine Auswertung von Reifenzustandsgrößen oder eine sonstige Funktion des Reifenmoduls auch während des Reifenstillstandes ausgeführt werden kann, ist vorgesehen, dass dem Gleichrichter ein elektrischer Energiespeicher, insbesondere ein Kondensator, zugeordnet ist. Dadurch ist es möglich, die überschüssige erzeugte Energie, die während des Betriebes des Reifens nicht benötigt wurde, zu speichern und zu einem geeigneten Zeitpunkt abzurufen.

Um eine komplette Moduleinheit zur Erfassung von Reifenzustandsgrößen zu erhalten, ist an die Umwandlungseinheit auch eine Auswerteeinrichtung zur Auswertung des elektrischen Ausgangssignals der Umwandlungseinheit oder anderer Sensordaten angeschlossen. So ist es möglich, beispielsweise auf der Basis des Zeitabstandes zwischen zwei Beschleunigungsimpulsen die Latschlänge, also die Größe der Aufstandsfläche des Reifens, zu bestimmen. Ebenfalls ist es möglich, die Raddrehzahl oder die Radlast zu bestimmen. Auch andere Sensoren, beispielsweise zur Erfassung des Luftdruckes oder der Reifentemperatur, können an der Auswerteeinheit angeschlossen sein.

Um die in der Auswerteeinheit erfassten bzw. errechneten Daten weiteren, im Fahrzeug befindlichen Systemen zugänglich machen zu können, ist vorteilhafterweise dem Reifenmodul ein Sender zugeordnet, mit dem die Reifenzustandsdaten an Steuersysteme oder zur Ausgabe an eine Anzeigeeinrichtung übermittelt werden. Mit einem solchen Reifenmodul lässt sich die Latschlänge mit Hilfe des kürzeren Abstandes zweier Impulse der Umwandlungseinheit bestimmen. Der zeitliche Verlauf und die Amplitude des Ausgangssignals der Umwandlungseinheit kann unmittelbar zur Bestimmung von Reifenzustandsgrößen verwendet werden.

Da sich bei sehr hohen Geschwindigkeiten sehr hohe Beschleunigungskräfte einstellen, besteht die Gefahr, dass bei einer frei eingespannten Feder diese bricht. Daher ist es vorgesehen, dass in dem Gehäuse Anschläge in Bewegungsrichtung des Federelementes ausgebildet sind, die eine Bewegung der Feder begrenzen. Vorteilhafterweise sind die Anschläge so ausgebildet, dass sie der Biegelinie des Federelementes entsprechen oder aber eine zu der Biegelinie des Federelementes geringere Krümmung aufweisen. Dadurch ist es möglich, dass das Federelement auf den Anschlägen abrollt, so dass die mechanischen Belastungen des Federelementes reduziert werden.

Eine Weiterbildung sieht vor, dass auf den Anschlägen elastisch ausgebildete Anschlagflächen angeordnet sind, so dass ein sanftes Abrollen auf den Anschlagflächen ermöglicht wird. Dabei ist es vorgesehen, dass die Anschlagflächen gummielastisch oder federelastisch ausgebildet sind, wobei bei einer gummielastischen Ausbildung die Verformungsenergie beim Abrollen in Wärme umgewandelt wird, während bei einer federelastischen Ausbildung der Anschlagflächen die Bewegungsenergie im System verbleibt und beim Nachschwingen in elektrische Energie umgewandelt werden kann. Werden die federelastischen Anschlagflächen als Anschlagfedern ausgebildet, haben diese vorteilhafterweise eine höhere Federkonstante als das Federelement mit der seismischen Masse, so dass auch bei hohen Geschwindigkeiten eine Federwirkung gewährleistet bleibt. Auch die Anschlagflächen sollten eine geringere Krümmung als die der Biegelinie des Federelementes aufweisen. Die Anschlagflächen können einstückig oder aus mehreren Segmenten oder Schichten zusammengesetzt ausgebildet sein, wobei eine segmentweise Ausbildung den Vorteil hat, die Federraten auf die Auslenkung des Federelementes abstimmen zu können.

Zusätzlich oder alternativ ist es vorgesehen, dass der seismischen Masse ein Amplitudenbegrenzer zugeordnet ist, um eine Zerstörung bei sehr hohen Geschwindigkeiten zu vermeiden.

Ein erfindungsgemäßer Luftreifen sieht vor, dass das oben beschriebene Reifenmodul auf der Reifeninnenseite angeordnet, insbesondere einvulkanisiert, ist. Durch die Anordnung des Federelementes in seiner Axialerstreckung parallel zu der Drehachse des Luftreifens kann die Erstreckung des Reifenmoduls in Umfangsrichtung minimiert werden. Hierdurch ist die Reibung zwischen dem Reifenmodul und der Innenseite des Reifens, dem so genannten "Innerliner", minimal, was die Dauerhaltbarkeit des Reifenmoduls bzw. des Systems aus Reifenmodul und Luftreifen verbessert.

Die Länge der Federelementes liegt bevorzugt im Bereich zwischen 8mm bis 40mm, die seismische Masse wiegt zwischen 0,5g und 5g und die Auslenkung der seismischen Masse beträgt zwischen 1mm und 15mm.

Neben einer piezoelektrischen oder induktiven Energiewandlung, kann auch eine kapazitive Energiewandlung erfolgen, indem das Federelement gegenüber den festen Anschlägen elektrisch aufgeladen wird. Bei einer Bewegung, die durch die Beschleunigungssprünge beim Latschein- und -austritt hervorgerufen wird, ändert sich die elektrische Spannung des Federelementes gegenüber den Anschlägen, sofern die Ladung auf dem Federelement konstant ist. Diese Ausgestaltung ist bei mikromechanischer Ausführung der Umwandlungseinheit vorteilhaft.

Nachfolgend werden Ausführungsbeispiele der Erfindung anhand der beigefügten Figuren näher erläutert. Es zeigen:
- Figur 1: eine schematische Darstellung eines Reifenmoduls mit einer Umwandlungseinheit in Schnittansicht,
- Figur 2: eine induktive Ausgestaltung einer Umwandlungseinheit,
- Figur 3: eine Variante der Figur 1,
- Figur 4: ein Schaltbild eines Reifenmoduls,
- Figur 5: eine Weiterentwicklung der Anordnung gemäß Figur 4, und
- Figur 6: eine Darstellung eines Reifenmoduls mit magnetischem Kurzschluss.

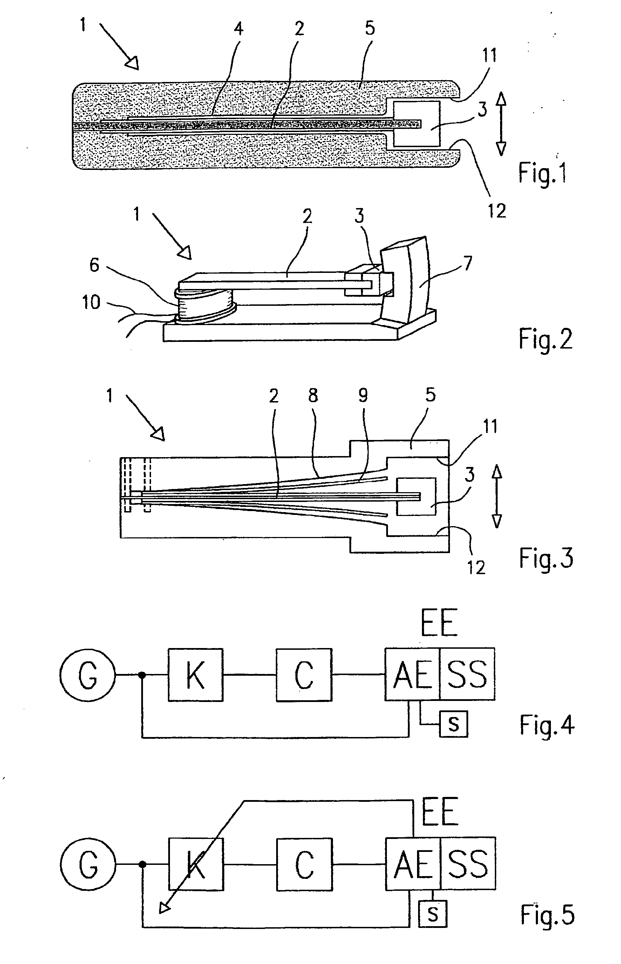

Figur 1 zeigt einen Schnitt durch ein Reifenmodul 1, das vorzugsweise auf der Innenseite eines Luftreifens, dem Laufstreifen gegenüberliegend, angeordnet ist. Das Gehäuse 5 weist einen Schlitz auf, in dem ein Federelement 2, vorliegend als Blattfeder ausgebildet, endseitig eingespannt ist. An dem, dem eingespannten Ende gegenüberliegenden Ende des Federelementes 2 ist eine seismische Masse 3 angeordnet, die aufgrund eines mechanischen Impulses in Schwingung versetzt wird. Das Federelement 2 bildet zusammen mit der seismischen Masse 3 einen Feder-Masseschwinger, der innerhalb des Gehäuses 5 eine oszillierende Bewegung ausführt. Auf der Oberseite und Unterseite des Federelementes 2 ist jeweils eine piezoelektrische Schicht 4 aufgebracht, die geeignet polarisiert und mit Kontaktflächen versehen ist. Die Anbringung ist so beschaffen, dass eine Auslenkung des Federelementes 2 zu einer Dehnung bzw. Stauchung der piezoelektrischen Schichten 4 führt. An nicht dargestellten Kontaktflächen kann eine elektrische Spannung abgegriffen werden, so dass die Bewegungsenergie aufgrund der oszillierenden seismischen Masse 3 über die piezoelektrischen Schichten 4 in elektrische Energie umgewandelt wird. Das Federelement 2 oder die Blattfeder wirkt dabei als ein Wegübersetzer, bei dem eine Auslenkung der seismischen Masse 3 um wenige Millimeter in eine Längenänderung des piezoelektrischen Materials 4 führt, was unter Ausnutzung des piezoelektrischen Effektes zu einer Erzeugung elektrischer Energie führt.

Das Reifenmodul 1 nutzt die auftretenden Beschleunigungssprünge zwischen einer Kreisbahn und dem Latschdurchtritt des Reifens zur Energieerzeugung, indem die seismische Masse 3 aufgrund der Beschleunigungssprünge beim Latscheintritt und Latschaustritt in Schwingung versetzt wird. Das erfindungsgemäße Reifenmodul 1 hat den Vorteil, dass die Energiewandlung nicht nur während der Beschleunigungssprünge während des Latscheintrittes und Latschaustrittes stattfindet, sondern auch während des Nachschwingens des schwingungsfähigen Feder-Masseschwingers nach dessen Anregung. Durch das Nachschwingen wird über einen längeren Zeitraum Bewegungsenergie in elektrische Energie umgewandelt. Durch die Verteilung der Energieabgabe über einen längeren Zeitraum ist ein höherer Wirkungsgrad als bei herkömmlichen piezoelektrischen Energiegeneratoren gegeben.

Ein weiterer Vorteil des erfindungsgemäßen Reifenmoduls ist die einfache und robuste Konstruktion, die eine kostengünstige Herstellung erlaubt. Dabei ist in der dargestellten Ausführungsform das Federelement 2 als eine Stahlblattfeder ausgebildet, jedoch können auch andere Materialien zum Einsatz kommen. In der Ausführungsform gemäß der Figur 1 ist die piezoelektrische Beschichtung 4 in Verbindung mit der Stauchung bzw. Dehnung durch die Schwingung die Umwandlungseinheit, in der Bewegungsenergie in elektrische Energieimpulse umgewandelt wird.

Alternativ kann die Anordnung der piezoelektrischen Schicht bzw. piezoelektrischen Elemente 4 so erfolgen, dass durch eine Stauchung in Bewegungsrichtung an dem Gehäuse 5 der piezoelektrische Effekt bewirkt wird, also, wenn die piezoelektrische Schicht 4 an der Gehäuseinnenwandung 5 anstößt.

Statt mit einer Umwandlungseinheit, die auf piezoelektrischen Effekten beruht, kann eine Energiewandlung mittels Induktion erfolgen. Ein mögliches Ausführungsbeispiel ist in der Figur 2 gezeigt, bei der das Federelement 2 als eine Blattfeder ausgebildet ist, an deren freiem Ende ein Permanentmagnet 3 als seismische Masse befestigt ist. Das eingespannte Ende der Blattfeder 2 ist auf einer Spule 6 gelagert, über Leitungen 10 werden die elektrischen Impulse beispielsweise an einen Gleichrichter geleitet. Bei dem Reifenmodul 1 gemäß der Figur 2 wird der Fluss eines magnetischen Kreises durch die Bewegung der Blattfeder 2 moduliert. Der magnetische Kreis wird vorzugsweise so aufgebaut, dass der Federstahl der Blattfeder 2 ein Teil des magnetischen Kreises ist, das heißt, dass der Fluss von der Blattfeder 2 geführt wird. Gespeist wird der magnetische Kreis von der als Permanentmagnet ausgebildeten seismischen Masse 3. Die Spule 6 kann an beliebiger Stelle über den Eisenkreis geschoben bzw. gewickelt werden, sollte aber möglichst den gesamten Fluss umfassen. Alternativ sind rotationssymmetrische Ausführungen des Generators vorstellbar, dem seismischen Element 3 gegenüberliegend ist das Joch 7 mit Polschuhen angeordnet. Das Joch 7 umfasst alle nicht bewegten, flußführenden Teile des magnetischen Kreises ohne den Erregermagneten selbst.

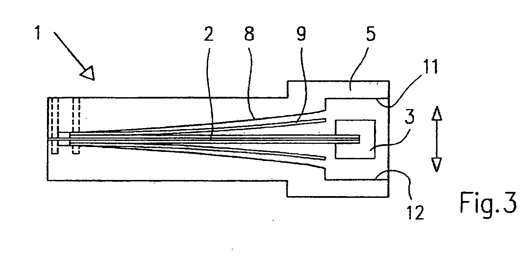

In der Figur 3 ist eine Variante des Reifenmoduls gemäß Figur 1 dargestellt, bei der in dem Gehäuse 5 in Bewegungsrichtung der seismischen Masse 3 Anschläge 8 ausgebildet sind, die der Biegelinie des Federelementes 2 in ihrer Kontur entsprechen. Bei einer relativ weichen Auslegung des Federelementes 2 kommt es bereits bei kleinen Beschleunigungssprüngen beim Latscheintritt und Latschaustritt, resultierend aus geringen Fahrzeuggeschwindigkeiten, zu einer großen Auslenkung der seismischen Masse 3. Eine weiche Auslegung des Federelementes 3 ist gewünscht, um auch bei geringen Fahrzeuggeschwindigkeiten verwertbare elektrische Spannung zu erhalten. Bei größeren Geschwindigkeiten mit entsprechend größeren Beschleunigungssprüngen werden die Auslenkungen der seismischen Masse 3 sehr groß, so dass das Federelement 3 brechen kann. Daher sind die Anschläge 8 vorgesehen, ebenso wie Amplitudenbegrenzer 11, 12 für die seismische Masse 3. Sowohl die Anschläge 8 als auch die Amplitudenbegrenzer 11, 12 können hart, gummielastisch oder feder-elastisch ausgeführt sein. Eine harte Ausführung ist am kostengünstigsten, hat jedoch den Nachteil einer hohen mechanischen Belastung des Federelementes 2 und der seismischen Masse 3. Bei gummielastischen Anschlägen 8 oder Amplitudenbegrenzern 11, 12 wird die überschüssige Energie in Wärme umgewandelt, während bei federelastischen Anschlägen 8 oder Amplitudenbegrenzern 11, 12 die angeregte Energie als Bewegungsenergie im System bleibt und beim Nachschwingen in elektrische Energie umgewandelt werden kann. Bei einer federelastischen Ausgestaltung ist es vorgesehen, dass Anschlagflächen oder -federn 9 auf oder vor den Anschlägen 8 ausgebildet sind, die eine höhere Federkonstante als das Federelement 2 haben, so dass auch bei hohen Geschwindigkeiten und entsprechend hohen Energien die Anschlagfedern 9 nicht auf Block gehen.

Sofern feste Anschläge 8 vorgesehen sind, ist die Kontur in Gestalt einer Biegelinie des Federelementes 2 vorteilhaft, so dass das Federelement 2 auf dem Anschlag 8 zur Anlage kommt; falls die Krümmung geringer als die der Biegelinie des Federelementes 2 sein sollte, rollt das Federelement 2 in der entsprechenden Auslenkung auf dem Anschlag 8 ab.

In der Figur 3 ist zu erkennen, dass die elastischen Anschlagfedern 9 ebenfalls die Form einer Biegelinie haben, gegebenenfalls mit einer geringeren Krümmung als die Biegelinie des Federelementes 2, wobei die Anschlagfedern 9 zusammen mit dem Federelement 2 in dem Gehäuse fest eingespannt sind. Bei ausreichend großen Auslenkungen der seismischen Masse 3 und damit Biegung des Federelementes 2 legt sich das Federelement 2 zunächst an die Anschlagfedern 9 an; hierdurch erhöht sich die Federkonstante der Gesamtanordnung.

Mit dieser Ausgestaltung kann das Reifemodul 1 sowohl bei kleinen Fahrzeuggeschwindigkeiten als auch bei hohen Geschwindigkeiten Energie liefern. Ohne die Ausgestaltung mit Anschlagfedern 9 wird die Zeit im Latschdurchtritt bei hohen Geschwindigkeiten für das Federelement 2 nicht ausreichen, um die seismische Masse 3 nennenswert aus ihrer Auflage zu heben. Daraus würden sehr kleine Bewegungsamplituden resultieren, was eine entsprechend kleine Energieabgabe zur Folge hätte. Um wenig Energie durch Reibprozesse zu verlieren, ist es vorgesehen, die Oberflächen des Federelementes 2 und der elastischen Anschlagflächen 9 bevorzugt so auszuführen, dass diese bei Anlage und Auslenkung nicht aufeinander gleiten können.

Bei der Ausgestaltung gemäß Figur 3 ist es vorteilhaft, wenn die Kontur des Anschlags 8 eine stärkere Krümmung aufweist als die der elastischen Anschlagflächen 9, so dass es mit steigender Fahrzeuggeschwindigkeit zunächst zur Anlage des Federelementes an der elastischen Anschlagfläche 9 und bei weiterer Erhöhung der Geschwindigkeit zur Anlage des Federelementes 2, zusammen mit der elastischen Anschlagfläche 9, an den festen Anschlag 8 kommt. Dies führt dazu, dass selbst bei höchsten Geschwindigkeiten keine Zerstörung des Federelementes bewirkt wird.

Alternativ zu einer einstückigen Ausbildung können mehrere Anschlagflächen 9 in Bewegungsrichtung der seismischen Masse 3 hintereinander angeordnet werden, so dass eine mehrfach linear gestufte Federkonstante verwirklicht wird.

Ebenfalls können progressive Federkennlinien dadurch realisiert werden, dass die elastischen Anschlagflächen 9 mit mehrfach gestuften Blattfedern ausgeführt werden, die unterschiedliche Längen haben. Je später die jeweilige Blattfeder zur Anlage kommt, umso kürzer und steifer ist diese, so dass sich progressive Federkennlinien realisieren lassen.

Anstelle von festen Anschlägen 8 oder Amplitudenbegrenzern 11, 12 kann das Reifenmodul 1 durch die Füllung mit einer geeigneten Flüssigkeit vor Zerstörung bei hohen Geschwindigkeiten geschützt werden, überschüssige Energie wird in Wärme umgesetzt und geht für die elektrische Energiegewinnung verloren.

Eine vorteilhafte Ausgestaltung und Anordnung sieht vor, dass das Reifenmodul 1 parallel zur Drehachse des Reifens bezüglich seiner Längserstreckung eingebaut wird, also dass das Federelement 2 parallel zur Radachse ausgerichtet ist. Dadurch wird die Erstreckung des Reifenmoduls 1 in Umfangsrichtung eines Reifens minimiert, was wiederum die Reibung zwischen dem Reifenmodul 1 und der Auflage auf einem Innerliner eines Luftreifens minimiert, was die Dauerhaltbarkeit der Anordnung verbessert.

Alternativ zu den beschriebenen Ausführungsformen mit einer Blattfeder 2 als Federelement kann das Reifenmodul auch zylindersymmetrisch ausgeführt werden. Im Fall der elektrodynamischen Energiewandlung schließt sich der Eisenkreis über die Zylinderwände, während der Permanentmagnet in der Zylinderachse liegt. Der Feder-Masseschwinger wird dann mit einer ebenfalls auf der Zylinderachse angeordneten seismischen Masse gebildet, die am Zylinderdeckel befestigt ist. Damit der Deckel die Funktion der Feder übernehmen kann, ist er mit konzentrischen Sicken versehen und aus Federstahl gefertigt. Durch die Beschleunigungssprünge beim Durchtritt durch die Reifenaufstandsfläche wird der Luftspalt zwischen Magnet und seismischer Masse verändert, wodurch sich der magnetische Fluss im Eisenkreis ändert. Die Flussänderung kann mit einer geeignet angeordneten Spule in eine elektrische Spannung umgewandelt werden.

Um die durch die Umwandlungseinheit oder den Energiegenerator gewonnene Energie sinnvoll nutzen zu können, muss die in der Regel als Wechselspannung vorliegende Spannung gleichgerichtet werden. In der Figur 4 ist eine Schaltungsanordnung mit einem Generator G gezeigt, der der Umwandlungseinheit der Figur 1 entspricht. Diese ist mit einem Konverter K verbunden, der die Wechselspannung in Gleichspannung umsetzt. Ein Speicherkondensator C ist mit dem Konverter K verbunden, um eine Energiespeicherung zu ermöglichen. Eine Elektronikeinheit EE, bestehend aus einer Auswerteeinheit AE und einer Sendestufe SS, ist dem Kondensator nachgeordnet. Die Generatorsignale werden ebenfalls unmittelbar der Auswerteeinheit AE zugeleitet, so dass aufgrund der Generatorausgangsgrößen, wie Spannung, Strom, Frequenz und Leistung, elektrische Signale der Auswerteeinheit AE übermittelt werden. Diese elektrischen Signale des Generators G stellen somit ein Maß für die im Reifen auftretenden mechanischen Anregungen dar. Da diese mechanischen Anregungen aber auch von den speziellen Gegebenheiten im jeweiligen Reifen abhängen, wie zum Beispiel Dimension, Profiltiefe oder Verformung, ist es möglich, Reifenzustandsgrößen aus den elektrischen Signalen des Generators G zu gewinnen. Als anschauliches Beispiel ist die Detektion der Latschlänge zu nennen. Aufgrund der Beschleunigungssprünge beim Latscheintritt und -austritt erfährt der Generator eine Anregung, die im elektrischen Signal als ein Impuls abgebildet wird. In der Auswerteeinheit AE erfolgt die Erfassung der Impulse für z. B. eine Reifenumdrehung und eine Berechnung der Latschlänge aufgrund der Zeitdauer zwischen den Impulsen. Die Berechnung kann auch in einem fahrzeugfesten Erfassungsgerät erfolgen. Dann werden nur die Impulse vom Reifenmodul übertragen und der zeitliche Abstand zwischen den Impulsen im Erfassungsgerät ausgewertet. Somit kann auf die Anbringung eines zusätzlichen Sensors verzichtet werden. Die Latschlänge und die Anzahl der Abrollvorgänge sind wichtige Eingangsgrößen für ein Verschleißmodell zur Ermittlung der Restlaufstrecke von Runflat-Reifen. Alternativ oder ergänzend kann jedoch ein weiterer Sensor S vorgesehen sein, der ebenfalls über den Kondensator C mit Energie versorgt wird und beispielsweise die Temperatur erfasst. Die ausgewerteten Daten werden über die Sendestufe SS an die Motor- oder Fahrwerksteuerung oder den Fahrzeugnutzer ausgegeben.

Da während der Aufladung des Kondensators C der Generator G durch die Impedanz des Kondensators C belastet wird und die Ausgangsspannung des Generators G im Vergleich zum Leerlauf verändert, kann diese Veränderung eine Erfassung der Reifenzustandsgrößen verhindern oder unzulässig erschweren. Daher ist es gemäß Figur 5 vorgesehen, dass der Gleichrichter oder Konverter K von der Elektronikeinheit EE dergestalt gesteuert wird, dass einmal der Kondensator C über den Konverter aufgeladen und der Generator G während dieser Zeitabschnitte mit der Kondensatorimpedanz belastet wird. Im alternativen Zustand wird der Gleichrichter K gesperrt, es kann also keine Aufladung des Kondensators C erfolgen. Dementsprechend wird der Generator G mit der Kondensatorimpedanz nicht belastet, so dass eine Erfassung der Reifenzustandsgrößen im unbelasteten Fall durchgeführt werden kann. Die Elektronikeinheit EE steuert die Umschaltung zwischen diesen beiden Zuständen derart, dass einerseits immer genügend Energie zur Versorgung des gesamten Systems bzw. Reifenmoduls zur Verfügung steht und andererseits die Erfassung der Reifenzustandsgrößen optimal erfolgt.

Die Anordnungen gemäß der Figuren 4 und 5, in denen ein Reifenmodul gemäß der Figuren 1 bis 3 eingesetzt werden kann, kann beispielsweise zur Ermittlung der Radlast oder zur Reifenprofiltiefenerkennung eingesetzt werden. Ebenfalls ist es möglich, dass ein Energiemanagementsystem in der Elektronikeinheit EE abgelegt ist, durch das es möglich ist, auch im Reifenstillstand Messgrößen zu erfassen und Daten zu einem empfangenden Steuergerät zu übermitteln. Dazu kann beispielsweise ein zusätzlicher Kondensator C aufgeladen werden, der ausschließlich zur Energieversorgung des Systems im Fahrzeugstillstand Verwendung findet. Die Steuerung der Lade- und Entladevorgänge dieses Kondensators wird von der Elektronikeinheit EE übernommen, so dass es möglich ist, einen schleichenden Druckverlust auch im Fahrzeugstillstand zu erkennen. In der Elektronikeinheit können auch reifenspezifische Daten gespeichert und an ein zentrales Steuergerät übermittelt werden, so dass Fahrdynamikregler optimal auf den jeweiligen Reifentyp eingestellt werden können. Beispielsweise wird ein Wechsel von Winter- auf Sommerreifen automatisch registriert. Auch kann das System gemäß der Figuren 4 und 5 zur Protokollierung der Reifenzustände eingesetzt werden, da es Größen, wie den Reifendruck, die gefahrene Strecke, Kräfte im Reifen, Beschleunigungssprünge und dergleichen, erfasst und gegebenenfalls abspeichert. So ist es z. B. möglich, festzustellen, ob der Reifen mit unzulässigen Drücken gefahren wurde und welche Fahrstrecke dabei zurückgelegt wurde. Des Weiteren können Fahrten über große Hindernisse, wie Bordsteine, erfasst werden, wobei diese Information zur Berechnung der Restlebensdauer des jeweiligen Reifens verwendet werden kann.

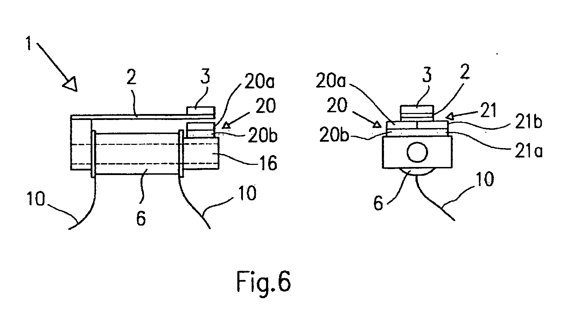

In der Figur 6 ist ein Reifenmodul 1 mit einer Energieumwandlungseinheit gezeigt, die auf dem Prinzip der Induktion beruht. Über einem Eisenkern 16 ist eine Spule 6 angeordnet, die über Kabel 10 mit einer nicht gezeigten Auswerteeinheit verbunden ist. An einem Ende des Eisenkerns 16 sind Erregermagnete 20, 21 gegensinnig angeordnet. An dem gegenüberliegenden Ende ist ein Federelement in Gestalt einer Blattfeder 2 einseitig schwingend befestigt. Zwischen den Erregermagneten 20, 21 ist ein Luftspalt ausgebildet, oberhalb des Luftspaltes und oberhalb der Erregermagnete 20, 21 ist eine seismische Masse 3 angeordnet. Wie in der rechten Darstellung der Figur 6 zu sehen ist, sind die Erregermagnete 20, 21 gegensinnig angeordnet, das heißt, dass der Nordpol 20a und der Südpol 21b der Erregermagnete 20, 21 einander gegenüberliegen, während der Südpol 20b und der Nordpol 21a der Erregermagnete 20, 21 einander gegenüberliegen. Für eine Spannungsinduktion wird ein zeitlich veränderlicher Fluss in dem magnetischen Kreis benötigt. Die Flussänderung wird gemäß der Figur 6 erzeugt, indem die Größe des Luftspaltes verändert oder ein magnetischer Kurzschluss durch die Bewegung der seismischen Masse 3 hervorgerufen wird. Die Induktion wird dabei durch die Modulation des Streuflusses der Magnete 20, 21 bewirkt. Bei einem Kurzschluss findet wenig Streufluss statt, bei einem Betrieb mit Luftspalt viel Streufluss, so dass eine erhöhte Spannungsinduktion bei einem Betrieb mit Luftspalt stattfindet.

Bei einer Anordnung gemäß Figur 2 wird die zeitliche Änderung des magnetischen Flusses durch die Änderung der Luftspaltlänge bei Auslenkung des Federelementes 2 erreicht. Bei einer Magnetisierung der Polschuhe ist eine größere Flussänderung zu erwarten, wobei gegebenenfalls die Polschuhe alternierend Nord-Süd-Nord-Süd magnetisiert werden können.

Mit dem erfindungsgemäßen Reifenmodul bzw. dem im Reifenmodul abgelegten System ist es möglich, sehr kostengünstig ein energieautarkes System mit nicht von einer Batterie abhängiger Lebensdauer zur Erfassung, Speicherung und Weiterverarbeitung von Reifenzustandsgrößen sowie fahrdynamischen Grö-βen zu verwirklichen. Das Reifenmodul ist vorteilhafterweise auf der Reifeninnenseite befestigt. Dem Reifenmodul ist eine Speichereinrichtung zugeordnet, in der Daten über Luftdruck und Dauer des Betriebes des Reifens mit einem entsprechenden Luftdruckdruck abgelegt werden. Wird ein Reifen über einen längeren Zeitraum mit zu wenig Luftdruck betrieben, kann dies zu einem erhöhten Verschleiß führen. Versagt der Reifen und kommt es zu einem Unfall, können diese Daten abgerufen werden, um belegen zu können, dass der Reifen unsachgemäß behandelt wurde und dass diese Behandlung des Reifens zu einem vorzeitigen Versagen geführt hat.

Vorteilhafterweise wird das Reifenmodul bei der Fertigung des Fahrzeuges während der Bremsenprüfung initialisiert und ggf. mit einer Identifikationsnummer versehen, die in einem Speicher abgelegt ist.

Das Reifenmodul kann auch Reifenschwingungen messen, beispielsweise im Bereich von 100Hz, um aus auftretenden Unregelmäßigkeiten auf Reifenschäden rückschließen zu können.

## Patentansprüche

1. Reifenmodul zur Erfassung von Reifenzustandsgrössen mit einem einseitig eingespannten Federelement und einer Umwandlungseinheit, in der Bewegungsenergie in elektrische Energie umgewandelt wird, wobei das Federelement (2) als Stab-, Torsions- oder Blattfeder ausgebildet ist, an deren nicht eingespanntem Ende eine seismische Masse (3) angeordnet ist, und Beschleunigungssprünge der seismischen Masse (3) auf die Umwandlungseinheit (2 , 3, 4 , 6, 7) überträgt, wobei ein zeitlicher Verlauf und eine Amplitude eines Ausgangssignals der Umwandlungseinheit unmittelbar zur Bestimmung von Reifenzustandsgrößen verwendet wird, **dadurch gekennzeichnet, dass** an die Umwandlungseinheit (4; 2, 3, 6, 7; G) ein Gleichrichter (K) angeschlossen ist, an den wiederum ein elektrischer Energiespeicher (C), insbesondere ein Kondensator, angeschlossen ist, wobei eine Steuereinheit (EE) dem Gleichrichter (K) zugeordnet ist, die wahlweise einen Impuls der Umwandlungseinheit (4; 2, 3, 6, 7; G) dem Gleichrichter (K) oder einer Auswerteeinheit (AE) zuleitet.

2. Reifenmodul nach Anspruch 1, **dadurch gekennzeichnet, dass** das Federelement (2) in einem Gehäuse (5) eingespannt ist und mit zumindest einem piezoelektrischen Element (4) gekoppelt ist, welches Bewegungsenergie in elektrische Energie umwandelt.

3. Reifenmodul nach Anspruch 2, **dadurch gekennzeichnet, dass** piezoelektrische Elemente (4) in jeder Bewegungsrichtung mit dem Federelement (2) mechanisch gekoppelt sind.

4. Reifenmodul nach Anspruch 2 oder 3, **dadurch gekennzeichnet, dass** das/die piezoelektrische (n) Element (e) (4) auf dem Federelement (2) befestigt ist/sind.

5. Reifenmodul nach mindestens einem der vorhergehenden Ansprüche, **dadurch gekennzeichnet, dass** an die Umwandlungseinheit (4 ; 2 , 3, 6, 7 ; G) die Auswerteeinheit (AE) zur Auswertung der elektrischen Impulse angeschlossen ist.

6. Reifenmodul nach Anspruch 5, **dadurch gekennzeichnet, dass** an die Auswerteeinheit (AE) ein Sensor (S) und/oder ein Sender (SS) angeschlossen ist.

7. Reifenmodul nach mindestens einem der vorhergehenden Ansprüche, **dadurch gekennzeichnet, dass** Anschläge (8) in Bewegungsrichtung des Federelementes (2) ausgebildet sind.

8. Reifenmodul nach Anspruch 7, **dadurch gekennzeichnet, dass** die Anschläge (8) der Biegelinie des Federelementes (2) entsprechen oder eine zu der Biegelinie des Federelementes (2) geringere Krümmung aufweisen.

9. Reifenmodul nach Anspruch 7 oder 8 , **dadurch gekennzeichnet, dass** auf den Anschlägen (8) elastisch ausgebildete Anschlagflächen (9), insbesondere Anschlagfedern, angeordnet sind.

10. Reifenmodul nach Anspruch 9, **dadurch gekennzeichnet, dass** die Anschlagflächen (9) eine geringere Krümmung als die der Anschläge (8) aufweisen.

11. Reifenmodul nach Anspruch 9 oder 10, **dadurch gekennzeichnet, dass** die Anschlagflächen (9) aus mehreren Segmenten oder Schichten zusammengesetzt sind.

12. Reifenmodul nach mindestens einem der vorhergehenden Ansprüche, **dadurch gekennzeichnet, dass** der seismischen Masse (3) Amplitudenbegrenzer (11, 12) zugeordnet sind.

13. Reifenmodul nach mindestens einem der Ansprüche 1 bis 4, **dadurch gekennzeichnet, dass** die Länge des Federelementes (2) im Bereich zwischen 8mm bis 40mm liegt, die seismische Masse (3) zwischen 0, 5g und 5g wiegt und die Auslenkung der seismischen Masse (3) zwischen 1 mm und 15 mm liegt.

14. Luftreifen mit einem Reifenmodul nach mindestens einem der vorhergehenden Ansprüche, **dadurch gekennzeichnet, dass** das Reifenmodul (1) auf der Reifeninnenseite angeordnet ist.

15. Luftreifen nach Anspruch 14, **dadurch gekennzeichnet, dass** das Federelement (2) in seiner Axialerstreckung parallel zu der Drehachse des Luftreifens angeordnet ist.

## Claims

1. Tyre module for detecting tyre state variables having a spring element which is clamped in on one side and a conversion unit in which kinetic energy is converted into electrical energy, wherein the spring element (2) is embodied as a bar spring, torsion spring or leaf spring, at whose non-clamped-in end a seismic mass (3) is arranged, and transmits sudden increases in acceleration of the seismic mass (3) to the conversion unit (2, 3, 4, 6, 7), wherein a time profile and an amplitude of an output signal of the conversion unit are used directly to determine tyre state variables, **characterized in that** a rectifier (K) is connected to the conversion unit (4; 2, 3, 6, 7; G), to which rectifier (K) an electrical energy accumulator (C), in particular a capacitor, is in turn connected, wherein a control unit (EE) is assigned to the rectifier (K), which control unit (EE) optionally feeds a pulse of the conversion unit (4; 2, 3, 6, 7; G) to the rectifier (K) or to an evaluation unit (AE).

2. Tyre module according to Claim 1, **characterized in that** the spring element (2) is clamped in a housing (5) and is coupled to at least one piezoelectric element (4) which converts kinetic energy into electrical energy.

3. Tyre module according to Claim 2, **characterized in that** piezoelectric elements (4) are mechanically coupled to the spring element (2) in each direction of movement.

4. Tyre module according to Claim 2 or 3, **characterized in that** the piezoelectric element or elements (4) is/are attached to the spring element (2).

5. Tyre module according to at least one of the preceding claims, **characterized in that** the evaluation unit (AE) for evaluating the electrical pulses is connected to the conversion unit (4; 2, 3, 6, 7; G).

6. Tyre module according to Claim 5, **characterized in that** a sensor (S) and/or a transmitter (SS) are/is connected to the evaluation unit (AE).

7. Tyre module according to at least one of the preceding claims, **characterized in that** stops (8) are formed in the direction of movement of the spring element (2).

8. Tyre module according to Claim 7, **characterized in that** the stops (8) correspond to the bending line of the spring element (2) or have a smaller curvature than that of the bending line of the spring element (2).

9. Tyre module according to Claim 7 or 8, **characterized in that** elastically constructed stop faces (9), in particular stop springs, are arranged on the stops (8).

10. Tyre module according to Claim 9, **characterized in that** the stop faces (9) have a smaller curvature than that of the stops (8).

11. Tyre module according to Claim 9 or 10, **characterized in that** the stop faces (9) are composed of a plurality of segments or layers.

12. Tyre module according to at least one of the preceding claims, **characterized in that** amplitude limiters (11, 12) are assigned to the seismic mass (3).

13. Tyre module according to at least one of Claims 1 to 4, **characterized in that** the length of the spring element (2) is in the range between 8 mm to 40 mm, the seismic mass (3) weighs between 0.5 g and 5 g and, the deflection of the seismic mass (3) is between 1 mm and 15 mm.

14. Pneumatic tyre having a tyre module according to at least one of the preceding claims, **characterized in that** the tyre module (1) is arranged on the inside of the tyre.

15. Pneumatic tyre according to Claim 14, **characterized in that** the spring element (2) is arranged with its axial extent parallel to the rotational axis of the pneumatic tyre.

## Revendications

1. Module de bandage de roue destiné à saisir des grandeurs d'état du bandage de roue et présentant
un élément élastique serré d'un côté et
une unité de conversion dans laquelle l'énergie du déplacement est convertie en énergie électrique,
l'élément élastique (2) étant configuré comme ressort en barreau, ressort de torsion ou ressort à lame à l'extrémité non serrée desquels une masse sismique (3) est disposée,
l'élément élastique transférant à l'unité de conversion (2, 3, 4, 6, 7) les sauts d'accélération de la masse sismique (3),
l'évolution dans le temps et l'amplitude d'un signal de sortie de l'unité de conversion étant utilisées directement pour déterminer des grandeurs d'état du bandage de roue,
**caractérisé en ce que**
un redresseur (K) auquel un accumulateur (C) d'énergie électrique, en particulier un condensateur, est raccordé est relié à l'unité de conversion (4; 2, 3, 6, 7; G) et
**en ce qu'**une unité de commande (EE) qui amène sélectivement une impulsion de l'unité de conversion (4; 2, 3, 6, 7; G) au redresseur (K) ou à une unité d'évaluation (AE) est associée au redresseur (K).

2. Module de bandage de roue selon la revendication 1, **caractérisé en ce que** l'élément élastique (2) est serré dans un boîtier (5) et est accouplé à un ou plusieurs éléments piézoélectriques (4) qui convertissent l'énergie du déplacement en énergie électrique.

3. Module de bandage de roue selon la revendication 2, **caractérisé en ce que** les éléments piézoélectriques (4) sont accouplés mécaniquement à l'élément élastique (2) dans chaque direction du déplacement.

4. Module de bandage de roue selon les revendications 2 ou 3, **caractérisé en ce que** les ou les éléments piézoélectriques (4) sont fixés sur l'élément élastique (2).

5. Module de bandage de roue selon au moins l'une des revendications précédentes, **caractérisé en ce que** l'unité d'évaluation (AE) est reliée à l'unité de conversion (4; 2, 3, 6, 7; G) pour évaluer les impulsions électriques.

6. Module de bandage de roue selon la revendication 5, **caractérisé en ce qu'**un détecteur (S) et/ou un émetteur (SS) sont raccordés à l'unité d'évaluation (AE).

7. Module de bandage de roue selon au moins l'une des revendications précédentes, **caractérisé en ce que** des butées (8) sont formées dans la direction du déplacement de l'élément élastique (2).

8. Module de bandage de roue selon la revendication 7, **caractérisé en ce que** les butées (8) correspondent à la ligne de flexion de l'élément élastique (2) ou présentent une courbure moindre que celle de la ligne de flexion de l'élément élastique (2).

9. Module de bandage de roue selon les revendications 7 ou 8, **caractérisé en ce que** des surfaces élastiques de butée (9), notamment des ressorts de butée, sont disposées sur les butées (8).

10. Module de bandage de roue selon la revendication 9, **caractérisé en ce que** les surfaces de butée (9) présentent une courbure moindre que celle des butées (8).

11. Module de bandage de roue selon les revendications 9 ou 10, **caractérisé en ce que** les surfaces de butée (9) sont constituées de l'assemblage de plusieurs segments ou couches.

12. Module de bandage de roue selon au moins l'une des revendications précédentes, **caractérisé en ce que** des limiteurs d'amplitude (11, 12) sont associés à la masse sismique (3).

13. Module de bandage de roue selon au moins l'une des revendications 1 à 4, **caractérisé en ce que** la longueur de l'élément élastique (2) est de l'ordre de 8 mm à 40 mm, la masse sismique (3) pèse entre 0,5 g et 5 g et la déviation de la masse sismique (3) est comprise entre 1 mm et 15 mm.

14. Bandage pneumatique de roue doté d'un module de bandage de roue selon au moins l'une des revendications précédentes, **caractérisé en ce que** le module de bandage de roue (1) est disposé sur le côté intérieur du bandage de roue.

15. Bandage pneumatique de roue selon la revendication 14, **caractérisé en ce que** l'élément élastique (2) est disposé avec son extension axiale parallèle à l'axe de rotation du bandage pneumatique de roue.
